(19) Europäisches Patentamt
European Patent Office
Office européen des brevets

(11) **EP 4 553 579 A1**

(12) **EUROPEAN PATENT APPLICATION**

(43) Date of publication:
**14.05.2025 Bulletin 2025/20**

(21) Application number: **23208139.8**

(22) Date of filing: **07.11.2023**

(51) International Patent Classification (IPC):
*G03F 7/20* (2006.01)

(52) Cooperative Patent Classification (CPC):
**G03F 7/70641; G03F 7/70683**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicant: **ASML Netherlands B.V.**
**5500 AH Veldhoven (NL)**

(72) Inventors:
• **OP 'T ROOT, Wilhelmus, Patrick, Elisabeth, Maria**
**5500 AH Veldhoven (NL)**
• **VAN DEN BOS, Karel, Hendrik, Wouter**
**5500 AH Veldhoven (NL)**
• **HOU, Zhe**
**5500 AH Veldhoven (NL)**
• **LEMMERS, Dorus**
**5500 AH Veldhoven (NL)**

(74) Representative: **ASML Netherlands B.V.**
**Corporate Intellectual Property**
**P.O. Box 324**
**5500 AH Veldhoven (NL)**

(54) **FOCUS METROLOGY METHOD AND METHOD FOR DESIGNING A FOCUS TARGET FOR FOCUS METROLOGY**

(57) Disclosed is a method of metrology, comprising obtaining a first measurement parameter value relating to at least a first sub-target; obtaining a third measurement parameter value relating to at least a third sub-target; and determining at least a focus parameter from at least said first measurement parameter value, said determination being normalized using at least said third measurement parameter value. The at least third sub-target comprising a normalization sub-target comprising substantially no or minimal focus sensitivity. Also disclosed is a method for designing a focus target.

Fig. 4

EP 4 553 579 A1

**Description**

<u>FIELD</u>

The present invention relates to metrology applications in the manufacture of integrated circuits.

<u>BACKGROUND</u>

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") at a patterning device (e.g., a mask) onto a layer of radiation-sensitive material (resist) provided on a substrate (e.g., a wafer).

To project a pattern on a substrate a lithographic apparatus may use electromagnetic radiation. The wavelength of this radiation determines the minimum size of features which can be formed on the substrate. Typical wavelengths currently in use are 365 nm (i-line), 248 nm, 193 nm and 13.5 nm. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Low-$k_1$ lithography may be used to process features with dimensions smaller than the classical resolution limit of a lithographic apparatus. In such process, the resolution formula may be expressed as CD = $k_1 \times \lambda$/NA, where $\lambda$ is the wavelength of radiation employed, NA is the numerical aperture of the projection optics in the lithographic apparatus, CD is the "critical dimension" (generally the smallest feature size printed, but in this case half-pitch) and $k_1$ is an empirical resolution factor. In general, the smaller $k_1$ the more difficult it becomes to reproduce the pattern on the substrate that resembles the shape and dimensions planned by a circuit designer in order to achieve particular electrical functionality and performance. To overcome these difficulties, sophisticated fine-tuning steps may be applied to the lithographic projection apparatus and/or design layout. These include, for example, but not limited to, optimization of NA, customized illumination schemes, use of phase shifting patterning devices, various optimization of the design layout such as optical proximity correction (OPC, sometimes also referred to as "optical and process correction") in the design layout, or other methods generally defined as "resolution enhancement techniques" (RET). Alternatively, tight control loops for controlling a stability of the lithographic apparatus may be used to improve reproduction of the pattern at low k1.

Metrology tools are used in many aspects of the IC manufacturing process, for example as alignment tools for proper positioning of a substrate prior to an exposure and scatterometry based tools for inspecting/measuring the exposed and/or etched product in process control; e.g., to measure overlay.

One important parameter of a lithographic process which requires monitoring is focus. There is a desire to integrate an ever-increasing number of electronic components in an IC. To realize this, it is necessary to decrease the size of the components and therefore to increase the resolution of the projection system, so that increasingly smaller details, or line widths, can be projected on a target portion of the substrate. As the critical dimension (CD) in lithography shrinks, consistency of focus, both across a substrate and between substrates, becomes increasingly important. CD is the dimension of a feature or features (such as the gate width of a transistor) for which variations will cause undesirable variation in physical properties of the feature. Traditionally, optimal settings were determined by "send-ahead wafers" i.e. substrates that are exposed, developed and measured in advance of a production run. In the send-ahead wafers, test structures are exposed in a so-called focus-energy matrix (FEM) and the best focus and energy settings are determined from examination of those test structures.

Another method of determining focus and/or dose has been through diffraction based focus techniques. Diffraction based focus may use target forming features on the reticle which print targets having a degree of asymmetry which is dependent on the focus and/or dose setting during printing. This degree of asymmetry can then be measured and the focus and/or dose inferred from the asymmetry measurement. Such focus measuring methods, and the associated test structure designs have a number of drawbacks. Many test structures require sub-resolution features or grating structures with large pitches. Such structures may contravene design rules of the users of lithographic apparatuses. Focus measuring techniques may comprise measuring asymmetry in opposite higher (e.g., first) order radiation scattered by special, focus dependent, target structures and determining focus from this asymmetry.

It would be desirable to improve on present focus metrology techniques, particularly in the context of EUV lithography.

<u>SUMMARY</u>

In a first aspect of the invention there is provided a method of metrology, comprising: obtaining a first measurement parameter value relating to at least a first sub-target; obtaining a third measurement parameter value relating to at least a third sub-target; and determining at least a focus parameter from at least said first measurement parameter value, said determination being normalized using at least said third measurement parameter value, said at least third sub-target comprising a normalization sub-target comprising substantially no or minimal focus sensitivity.

In a second aspect of the invention there is provided a method of designing a focus target, comprising: obtaining a pool of candidate sub-targets; obtaining measurement parameter data comprising respective measurement parameter values for each candidate sub-target in said pool of candidate sub-targets, over a focus range of interest and a dose range of interest; fitting, per candidate sub-target, said measurement parameter values over focus and dose in terms of a plurality of fit coefficients; determining, from said plurality of fit coefficients, a plurality of delta coefficients for different pairs of said candidate sub-targets; and assessing said plurality of delta coefficients against one or more criteria to determine one or more viable targets, each viable target comprising a viable combination of candidate sub-targets.

BRIEF DESCRIPTION OF THE DRAWINGS

Embodiments of the invention will now be described, by way of example only, with reference to the accompanying schematic drawings, in which:

- Figure 1 depicts a lithographic system comprising a lithographic apparatus and a radiation source;

- Figure 2 depicts a schematic overview of a lithographic cell;

- Figure 3 depicts a schematic representation of holistic lithography, representing a cooperation between three key technologies to optimize semiconductor manufacturing;

- Figure 4(a) and Figure 4(b) each illustrate a proposed target design comprising at least one designated normalization sub-target, according to a first embodiment;

- Figure 5 illustrates a proposed target design comprising at least one designated normalization sub-target, according to a second embodiment;

- Figure 6(a), Figure 6(b) and Figure 6(c) each illustrate possible candidate sub-target variations which may be used in a target design method according to an embodiment;

- Figure 7 is a flowchart describing a target design method according to an embodiment; and

- Figure 8 is a flowchart describing the final step of the target design method of Figure 7 according to an embodiment.

DETAILED DESCRIPTION

In the present document, the terms "radiation" and "beam" are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range of about 5-100 nm).

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

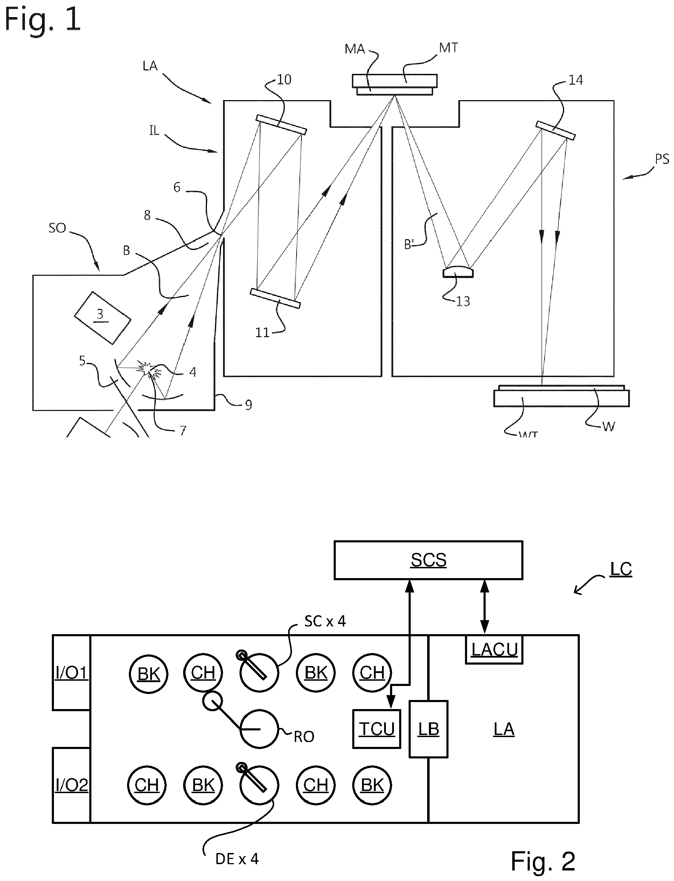

Figure 1 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and a substrate table WT configured to support a substrate W.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13,14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13,14 in Figure 1, the projection system PS may include a different number of mirrors (e.g., six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The radiation source SO shown in Figure 1 is, for example, of a type which may be referred to as a laser produced plasma (LPP) source. A laser system 1, which may, for example, include a $CO_2$ laser, is arranged to deposit energy via a laser beam 2 into a fuel, such as tin (Sn) which is provided from, e.g., a fuel emitter 3. Although tin is referred to in the following description, any suitable fuel may be used. The fuel may, for example, be in liquid form, and may, for example, be a metal or alloy. The fuel emitter 3 may comprise a nozzle configured to direct tin, e.g. in the form of droplets, along a trajectory towards a plasma formation region 4. The laser beam 2 is incident upon the tin at the plasma formation region 4. The deposition of laser energy into the tin creates a tin plasma 7 at the plasma formation region 4. Radiation, including EUV radiation, is emitted from the plasma 7 during de-excitation and recombination of electrons with ions of the plasma.

The EUV radiation from the plasma is collected and focused by a collector 5. Collector 5 comprises, for example, a near-normal incidence radiation collector 5 (sometimes referred to more generally as a normal-incidence radiation collector). The collector 5 may have a multilayer mirror structure which is arranged to reflect EUV radiation (e.g., EUV radiation having a desired wavelength such as 13.5 nm). The collector 5 may have an ellipsoidal configuration, having two focal points. A first one of the focal points may be at the plasma formation region 4, and a second one of the focal points may be at an intermediate focus 6, as discussed below.

The laser system 1 may be spatially separated from the radiation source SO. Where this is the case, the laser beam 2 may be passed from the laser system 1 to the radiation source SO with the aid of a beam delivery system (not shown) comprising, for example, suitable directing mirrors and/or a beam expander, and/or other optics. The laser system 1, the radiation source SO and the beam delivery system may together be considered to be a radiation system.

Radiation that is reflected by the collector 5 forms the EUV radiation beam B. The EUV radiation beam B is focused at intermediate focus 6 to form an image at the intermediate focus 6 of the plasma present at the plasma formation region 4. The image at the intermediate focus 6 acts as a virtual radiation source for the illumination system IL. The radiation source SO is arranged such that the intermediate focus 6 is located at or near to an opening 8 in an enclosing structure 9 of the radiation source SO.

Although Figure 1 depicts the radiation source SO as a laser produced plasma (LPP) source, any suitable source such as a discharge produced plasma (DPP) source or a free electron laser (FEL) may be used to generate EUV radiation.

As shown in Figure 2 the lithographic apparatus LA may form part of a lithographic cell LC, also sometimes referred to as a lithocell or (litho)cluster, which often also includes apparatus to perform pre- and post-exposure processes on a substrate W. Conventionally these include spin coaters SC to deposit resist layers, developers DE to develop exposed resist, chill plates CH and bake plates BK, e.g. for conditioning the temperature of substrates W e.g. for conditioning solvents in the resist layers. A substrate handler, or robot, RO picks up substrates W from input/output ports I/O1, I/O2, moves them between the different process apparatus and delivers the substrates W to the loading bay LB of the lithographic apparatus LA. The devices in the lithocell, which are often also collectively referred to as the track, are typically under the control of a track control unit TCU that in itself may be controlled by a supervisory control system SCS, which may also control the lithographic apparatus LA, e.g. via lithography control unit LACU.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), etc. For this purpose, inspection tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus, which may also be referred to as a metrology apparatus, is used to determine properties of the substrates W, and in particular, how properties of different substrates W vary or how properties associated with different layers of the same substrate W vary from layer to layer. The inspection apparatus may alternatively be constructed to identify defects on the substrate W and may, for example, be part of the lithocell LC, or may be integrated into the lithographic apparatus LA, or may even be a stand-alone device. The inspection apparatus may measure the properties on a latent image (image in a resist layer after the exposure), or on a semi-latent image (image in a resist layer after a post-exposure bake step PEB), or on a developed resist image (in which the exposed or unexposed parts of the resist have been removed), or even on an etched image (after a pattern transfer step such as etching).

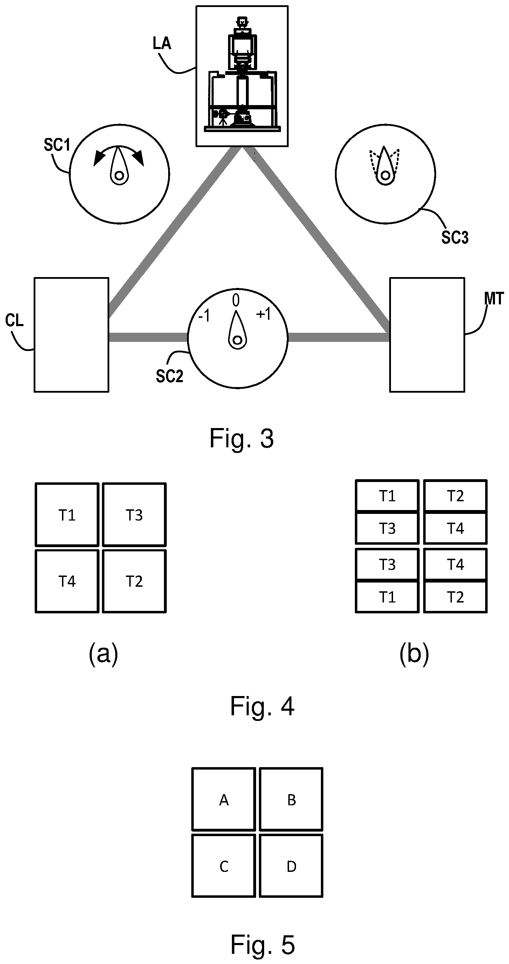

Typically the patterning process in a lithographic apparatus LA is one of the most critical steps in the processing which requires high accuracy of dimensioning and placement of structures on the substrate W. To ensure this high accuracy, three systems may be combined in a so called "holistic" control environment as schematically depicted in Fig. 3. One of these systems is the lithographic apparatus LA which is (virtually) connected to a metrology tool MT (a second system) and to a computer system CL (a third system). The key of such "holistic" environment is to optimize the cooperation between these three systems to enhance the overall process window and provide tight control loops to ensure that the patterning performed by the lithographic apparatus LA stays within a process window. The process window defines a range of process parameters (e.g. dose, focus, overlay) within which a specific manufacturing process yields a defined result (e.g. a functional semiconductor device) - typically within which the process parameters in the lithographic process or patterning process are allowed to vary.

The computer system CL may use (part of) the design layout to be patterned to predict which resolution enhancement techniques to use and to perform computational lithography simulations and calculations to determine which mask layout and lithographic apparatus settings achieve the largest overall process window of the patterning process (depicted in Fig. 3 by the double arrow in the first scale SC1). Typically, the resolution enhancement techniques are arranged to match the patterning possibilities of the lithographic apparatus LA. The computer system CL may also be used to detect where within the process window the lithographic apparatus LA is currently operating (e.g. using input from the metrology tool MT) to predict whether defects may be present due to e.g. sub-optimal processing (depicted in Fig. 3 by the arrow pointing "0" in the second scale SC2).

The metrology tool MT may provide input to the computer system CL to enable accurate simulations and predictions, and may provide feedback to the lithographic apparatus LA to identify possible drifts, e.g. in a calibration status of the lithographic apparatus LA (depicted in Fig. 3 by the multiple arrows in the third scale SC3).

In lithographic processes, it is desirable to make frequently measurements of the structures created, e.g., for process control and verification. Tools to make such measurement are typically called metrology tools MT. Different types of metrology tools MT for making such measurements are known, including scanning electron microscopes or various forms of scatterometer metrology tools MT. Scatterometers are versatile instruments which allow measurements of the parameters of a lithographic process by having a sensor in the pupil or a conjugate plane with the pupil of the objective of the scatterometer, measurements usually referred as pupil based measurements, or by having the sensor in the image plane or a plane conjugate with the image plane, in which case the measurements are usually referred as image or field based measurements. Such scatterometers and the associated measurement techniques are further described in patent applications US20100328655, US2011102753A1, US20120044470A, US20110249244, US20110026032 or EP1,628,164A, incorporated herein by reference in their entirety. Aforementioned scatterometers may measure gratings using light from soft x-ray and visible to near-IR wavelength range.

When monitoring a lithographic process, it is desirable to monitor a lithographic process parameter such as a focus parameter, describing focus of the lithography beam on the substrate. One known method of determining the focus parameter from a printed structure is by micro-diffraction based focus ($\mu$DBF). Micro-diffraction based focus may use target forming features on the reticle which print targets having a degree of asymmetry which is dependent on the focus setting during printing. This degree of asymmetry can then be measured using a scatterometry based inspection method, for example by measuring the intensity asymmetry between the intensities of + 1st and -1st order radiation diffracted from the target, to obtain a measure of the focus setting. The focus-dependent asymmetry may be achieved by providing "sub-resolution features" (also known as sub-resolution assist features), which are below the resolution limit of the lithographic apparatus being used to expose the target. Because these sub-resolution features are below this resolution limit, they are not actually formed on the substrate, instead they affect the formation of other (larger) adjacent features which are resolved. In particular, by placing these sub-resolution features along only one wall of the larger feature, the wall formation (e.g., the side wall angle) of this wall will depend on focus. In this way, the symmetry (or asymmetry) of the larger feature will be focus dependent.

This $\mu$DBF approach is generally effective for DUV focus parameter monitoring. However, with EUV lithographic apparatuses, the resolution of the lithographic apparatus is greater such that the smaller features (e.g., assist features) of the target are resolved, weakening the signal from such a target. Also, EUV lithography uses thinner resists which also means that the signal is typically weaker for EUV $\mu$DBF than for DUV $\mu$DBF. To address the signal strength issue, an alternative EUV focus metrology technique, hereafter referred to as feature bias focus metrology, may use a target comprising a pair of focus sub-targets, where each sub-target has the well-known Bossung curve relationship with focus, i.e., comprising a respective Bossung curve which peaks at best focus, and where each of the sub-targets may be formed with respective different best focus values and partially overlapping Bossung curves. Optionally, each of the Bossung curve relationships may be substantially similar, other than the best focus offset.

This latter metrology technique may use a target comprising at least a first sub-target and a second sub-target which have been formed with a best focus offset df between the two sub-targets. The focus response with a measurement value for a sub-target parameter may take the form of a Bossung curve for each of the first and second sub-targets. Focus is a function of a first measurement value of a sub-target parameter obtained from measurement of the first sub-target and a second measurement value of a sub-target parameter obtained from measurement of the second sub-target. Therefore, it is proposed that measured values of a parameter from the first and second sub-targets be obtained and a value for focus derived from these measured values. The measurement parameter may be an intensity parameter, e.g., an intensity of at least one diffraction order (e.g., the zeroth order and/or one or more first diffraction orders). The monotonic relationship may be obtained through a comparison (e.g., a difference) of the measured value(s) from the first sub-target and the measured value(s) from a second sub-target (optionally divided by an average measurement value over the two sub-targets).

In an embodiment, the best focus offset may be obtained via induced astigmatism, e.g., using astigmatism based focus (ABF) techniques, wherein an astigmatism may be induced in the imaging lens and/or reticle. ABF is described in US2016363871A1, which is incorporated herein by reference. Inducing astigmatism may be non-ideal as it cannot be used for production monitoring. Therefore other methods may be used to obtain a suitable best focus offset, e.g., in terms of differences in target parameters between the first sub-target and second sub-target.

In order to improve EUV layer focus performance, one approach may comprise printing a large number (e.g., hundreds or thousands) of focus targets on the EUV wafer and measuring all of them to find the best performance target. This brute-force method does not always guarantee that a good focus target design will be found, and is time consuming and costly. Another approach may be optimize current DUV target designs for each EUV layer. This however can be very slow and again is not guaranteed to provide a satisfactory target.

Many of the metrology techniques described above comprise measuring first order signals and looking at differences between them. As such, it does not guarantee intensity matching between different metrology tools. Metrology tools may be subject to dose (exposure apparatus source intensity) variation between tools and/or over time (e.g., during exposure of a substrate) for a single tool. Therefore, the measurement signal may be normalized to enable tool matching. Nowadays, for focus metrology the same targets used to generate focus sensitivity are used to also normalize the measured signal. For ($\mu$)ABF and feature bias focus metrology, the measurement parameter value or intensity metric asymmetry (intensity asymmetry) $I_{T1}$ - $I_{T2}$ between the first and second sub-targets T1, T2 is normalized by the sum intensity metric (sum intensities) of both targets: $Asymmetry = \frac{I_{T1}-I_{T2}}{I_{T1}+I_{T2}}$ . Each of the measured intensity metrics may optionally comprise an average of intensities of each of two complementary diffraction orders (e.g. +1 and -1 orders) from each respective target. For ($\mu$)DBF, this means the intensity metric asymmetry or intensity asymmetry $I^{+1st}$ - $I^{-1st}$ between the 1st orders from the $\mu$DBF sub-target is normalized by the sum intensity of both 1$^{st}$ orders:

$$Asymmetry = \frac{I^{+1st}-I^{-1st}}{I^{+1st}+I^{-1st}}.$$

However, because the resist thickness is small for EUV lithography, the signal strength / diffraction efficiency (DE) of the measured targets is low. This low DE means that the present sensing calibrations are not efficient enough in calibrating out intensity errors. If the signal is normalized by the sum intensity, any consistent error in the measured intensity is included in the measured asymmetry, e.g. (in the context of feature bias focus metrology):

$$Asymmetry = \frac{(I_{T1} + Error) - (I_{T2} + Error)}{(I_{T1} + Error) + (I_{T2} + Error)} \approx \frac{I_{T1} - I_{T2}}{I_{T1} + I_{T2}}\left(1 - \frac{2 \times Error}{I_{T1} + I_{T2}}\right)$$

In order to become less sensitive to errors on the measured intensity, one option is to improve the focus sensitivity of the target. Therefore, the relative (focus) impact of an intensity error will become smaller. In focus metrology, finding a good target is typically a balance between sensitivity to scanner focus and dose/energy. Many present focus sensitivity targets also show large sensitivity to dose, and many present target selection strategies search for a target combination which largely cancels dose sensitivity. However, the normalized asymmetry formula limits this behaviour as the normalization may comprise a division by the sum, such that dose sensitivities are still comprised in the measured asymmetry, e.g.:

$$Asymmetry = \frac{(I_{T1}+DoseXTalk)-(I_{T2}+DoseXTalk)}{(I_{T1}+DoseXTalk)+(I_{T2}+DoseXTalk)} \approx \frac{I_{T1}-I_{T2}}{I_{T1}+I_{T2}}\left(1 - \frac{2 \times DoseXTalk}{I_{T1}+I_{T2}}\right).$$

It may also be desirable to disentangle focus and dose sensitivity and/or individually measure (scanner) focus and (scanner) dose. This allows improvement in control of both focus and dose during exposure, using the measured focus and dose values.

Ghost or stray light calibrations, e.g., calibrations for "ghosts" or stray light within the sensor optics should be performed on a (e.g., production) wafer. However, no dedicated space is necessarily available for this ghost calibration on a production wafer, and the error is instead approximated using a metrology tool fiducial. This can be inaccurate and even add an error offset.

The concepts disclosed herein relate to methods of focus (and optionally dose) metrology and/or to methods of target selection for focus (and optionally dose) metrology. In particular, the methods disclosed herein may address one or more of the problems described above.

In an embodiment, the method may comprise providing one or more normalization sub-targets and using measurements of these normalization sub-targets to normalize the focus (and optionally dose) measurements. The one or more normalization sub-targets may be dedicated normalization sub-targets such that measurement data (e.g., the measured signal) from said normalization sub-target(s) is used for the sole purpose of normalization. Such one or more normalization sub-targets may each comprise a design that has no or minimal sensitivity to scanner focus (e.g., below a threshold focus sensitivity for example). The one or more normalization sub-targets may also comprise no or minimal sensitivity to scanner dose, e.g., below a threshold dose sensitivity for example. This may be the case where only a single normalization sub-target is provided. Alternatively, or in addition, where a pair of normalization sub-targets are provided, they may have substantially the same dose sensitivity, such that a signal difference over the two targets can be taken for which the dose sensitivity cancels. In either case, such a focus threshold may be set with reference to the focus sensitivity of the one or more focus sensitivity targets or the focus sensitivity of their difference. For example, the maximum threshold may be 5%, 10%, 15% or 20% of signal change through focus in denominator (e.g., $I_{T3}$ - $I_{T4}$) with respect to the numerator ($I_{T1}$ - $I_{T2}$). In another embodiment, these focus and/or dose thresholds may comprise a normalization second delta coefficient threshold value $\beta_{max}$ and a normalization third delta coefficient threshold value $\gamma_{max}$. These will be described in more detail later.

The one or more normalization sub-target(s) can be placed next to the one or more focus sensitive sub-target(s) in a single target, such that the full target can be measured in a single capture.

Figure 4(a) is an example target design for feature bias or ABF metrology. The target comprises a first sub-target T1 and second sub-target T2, e.g., two focus sensitive sub-targets (e.g., comprising a best focus offset between them as has been described). The target further comprises at least one third sub-target or normalization sub-target, and in this specific example two third sub-targets or normalization sub-targets T3, T4. Figure 4(b) shows a further target design, where the area of the first and second sub-targets or focus sensitive sub-targets T1, T2 is split to accommodate the third/normalization sub-targets T3, T4 therebetween. Other layouts are possible. For example, the concepts disclosed may be used with μDBF targets in μDBF metrology (in which case only one focus-sensitive sub-target is strictly required, although two mirrored sub-targets may be preferred).

These normalization sub-targets enable a normalized focus sensitive asymmetry signal to be determined as (e.g., in a feature bias example) as:

$$Asymmetry = \frac{I_{T1} - I_{T2}}{I_{T3} - I_{T4}}.$$

where $T1$, $T2$ are the respective intensities of the two focus sensitive sub-targets and T3, T4 are the respective intensities of the two normalization sub-targets. Assuming all sub-targets are measured in a single acquisition, consistent errors will be calibrated out automatically:

$$Asymmetry = \frac{(I_{T1} + Error) - (I_{T2} + Error)}{(I_{T3} + Error) - (I_{T4} + Error)} \approx \frac{I_{T1} - I_{T2}}{I_{T3} - I_{T4}}.$$

Similarly, where the method comprises μDBF metrology techniques, the normalized focus sensitive asymmetry signal may be calculated, for example, as:

$$Asymmetry = \frac{I^{T1+1st} - I^{T1-1st}}{I^{T3+1st} - I^{T3-1st}}$$

where two focus sensitive sub-targets and two normalized sub-targets are provided, the asymmetry measurements of these can be combined.

In an embodiment, the two normalization sub-targets can be chosen such that they each have similar dose sensitivity to the two focus sensitive sub-targets, in order to cancel out dose crosstalk more effectively:

$$Asymmetry = \frac{(I_{T1} + DoseXTalk) - (I_{T2} + DoseXTalk)}{(I_{T3} + DoseXTalk) - (I_{T4} + DoseXTalk)} \approx \frac{I_{T1} - I_{T2}}{I_{T3} - I_{T4}}.$$

Because this method enables calibration of the dose crosstalk of the focus sub-target, it also enables both focus metrology and dose metrology. By combining these targets with a conventional calculation of the focus-sensitivity asymmetry (which is sensitive to dose), e.g., $\frac{I_{T1} - I_{T2}}{I_{T1} + I_{T2}}$, it is possible to extract both focus and dose information.

A more robust focus and dose metrology method and target selection method will now be described, the method also making use of a normalization sub-target. The method may use a target such as illustrated in Figure 5, comprising a first sub-target B, second sub-target C, third sub-target D and fourth sub-target A. Once again, the target may be configured to be captured in a single measurement acquisition.

The concepts described may be based upon the feature bias concept, and as such may comprise largely or substantially symmetrical sub-targets (e.g., all of the sub-targets may be substantially symmetrical). The sub-targets may comprise two substantially focus sensitive sub-targets, first sub-target B and second sub-target C, and two substantially focus insensitive sub-targets: third sub-target D and fourth sub-target A. The target may be configured to generate first and second focus-sensitive signals. In such a method, it is proposed that the first focus-sensitive (and dose-sensitive) signal $Signal_1$ and second focus-sensitive (and dose-sensitive) signal $Signal_2$ may be defined as:

$$Signal_1 = \frac{I_A - I_B}{I_A - I_D}, \qquad Signal_2 = \frac{I_A - I_C}{I_A - I_D}$$

where $I_A$, $I_B$, $I_C$, $I_D$ are respectively the fourth, first, second and third measurement parameter values or intensity metrics from sub-targets A, $B$, $C$ and $D$ respectively. The intensity metric may comprise the intensities of at least one order (e.g., zeroth order or diffracted non-zero order of radiation scattered by each sub-target). In an embodiment, each of the measured intensity metrics may comprise an average of intensities of each of two complementary diffraction orders (e.g., +1 and -1 diffraction orders) having diffracted from a respective sub-target, e.g.: $I = (I_{+1} + I_{-1})/2$.

In this manner, the first signal may be a difference of a measurement parameter such as an intensity metric from fourth sub-target A and from first sub-target B (e.g., A-B), and the second signal may be a difference of a measurement parameter such as an intensity metric from fourth sub-target A and from second sub-target C (e.g., A-C), each normalized by the difference of the measurement/intensity metric from fourth sub-target A with the measurement/intensity metric from third sub-target D. The presence of a measurement of fourth sub-target A in all the terms addresses the stray light offset, while the third sub-target D may be the normalization sub-target.

In such a method, a calibration may be performed in a calibration or recipe optimization stage, which calibrates first signal $Signal_1$ and second signal $Signal_2$ through varied Dose and varied Focus (e.g., over a dose range of interest and a focus range of interest), to obtain optimization signal data $Signal_n^{RO}(F,D)$ (i.e., first optimization signal data $Signal_1^{RO}(F,D)$ and second optimization signal data $Signal_2^{RO}(F,D)$). For example, optimization signal data $Signal_n^{RO}(F,D)$ may comprise a 2D fit of the measured $Signal_1^{RO}(F,D)$ and $Signal_2^{RO}(F,D)$ through dose and focus. In a production or monitor phase, the dose and focus can then be inferred by finding the focus and dose which minimizes a comparison of the measurement or monitor signal data $Signal_n^{monitor}$ and the optimization signal data $Signal_n^{RO}(F,D)$:

$$error(F,D) = \sqrt{\sum_{N=1}^{2} \left( Signal_n^{RO}(F,D) - Signal_n^{monitor} \right)^2}$$

such a minimization may comprise finding at least one local error minimum with a desired trends, e.g., around an expected focus and/or dose value and/or within expected ranges for focus and dose. This may be done for one more measurement conditions (e.g., wavelength and polarization combination). For example, $Signal_n^{RO}(F,D)$ and $Signal_n^{monitor}$ may relate to more than one measurement condition.

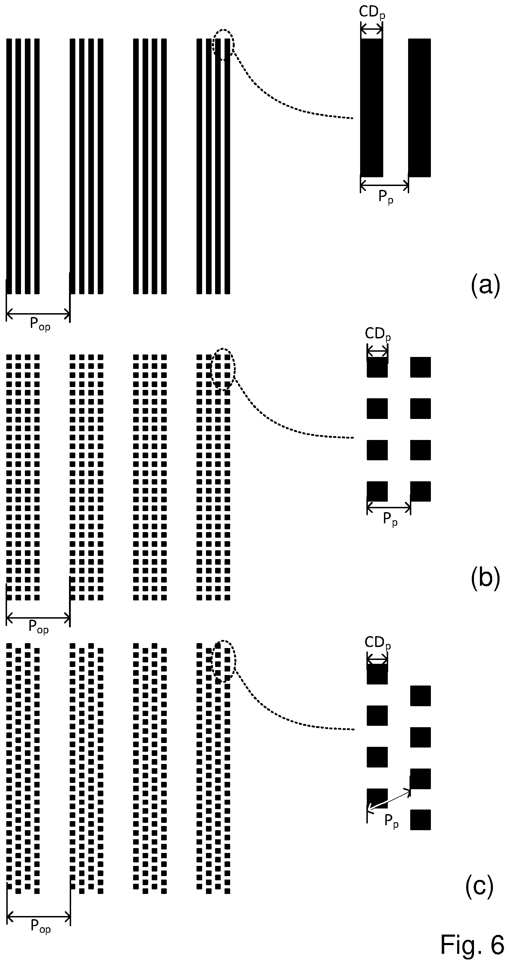

A target design method will now be described, for selecting each of the sub-targets A, B, C, D from a pool of candidate sub-target designs. The candidate sub-targets may comprise designs of the general form illustrated in Figure 6.

In Figure 6(a), the target may comprise segmented features on an optical pitch $P_{op}$ detectable by the metrology tool. The segmentation of the features may form a segmentation pitch (or product-like pitch, e.g., having a pitch of a similar size as the product features) $P_p$, with each segmentation sub-feature having a product-like critical dimension (CD) $CD_p$. Figure 6(b) shows a similar arrangement, but with each segmentation sub-feature further sub-segmented in the y direction so as to mimic a contact hole arrangement. Figure 6(c) shows a similar arrangement again, but where there is a periodic $\gamma$-offset between adjacent segmentation sub-features, resulting in a tilted or angled segmentation pitch $P_p$. The angle of the segmentation pitch $P_p$ may be, for example 30, 45 or 60 degrees.

The pool of candidate sub-targets may comprise many variations of designs such as these (and others), wherein one or more of *inter alia:* the optical pitch, segmentation pitch in x and/or y, segmentation $\gamma$-offset, segmentation CD may be varied over the pool of candidate sub-targets. For example, the pool of candidate sub-targets may number more than 40, more than 50, more than 60, more than 70, more than 80 or more than 90.

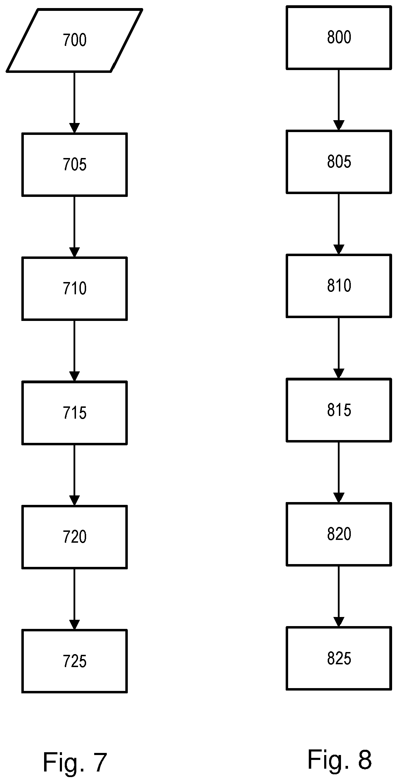

Figure 7 is a flowchart describing a proposed target design method. A pool of candidate sub-targets 700 is obtained (e.g., virtually, i.e., in simulation) and measured (e.g., again virtually or in simulation) to obtain respective measurement parameter or intensity metric values for each candidate sub-target for different values of a focus metric (e.g., scanner focus) and dose metric (e.g., scanner dose). The resultant measurement parameter data or intensity metric data may optionally further relate to one or more measurement conditions (e.g., different wavelengths and/or polarizations).

At step 705, the intensity metric values are fitted with a 2D curve to obtain a 2D fit of intensity $Intensity_m$ per candidate sub-target. The fit may be made in terms of six fit coefficients, a constant coefficient $p_{00}^m$, a dose coefficient $p_{01}^m$, a focus coefficient $p_{10}^m$, focus-dose product coefficient $p_{11}^m$, a focus-squared coefficient $p_{20}^m$, and a focus-squared-dose product coefficient $p_{21}^m$, e.g.,:

$$Intensity_m = (p_{00}^m + p_{01}^m \cdot D) + (p_{10}^m + p_{11}^m \cdot D) \cdot F + (p_{20}^m + p_{21}^m \cdot D) \cdot F^2$$

with m indexing the different candidate sub-targets.

At step 710, delta coefficients of delta signals are determined. For all unique dual candidate sub-target combinations (e.g., approx. 5000 for approx. 100 candidate sub-targets), a first delta coefficient $\alpha_{mk}$ [unit: diffraction efficiency DE (in simulations) or gray levels GL (in reality)], a second delta coefficient $\beta_{mk}$ [unit: DE/nm or GL/nm] and a third delta coefficient $\gamma_{mk}$ [unit: DE/nm$^2$ or GL/nm$^2$] may be determined as:

$$\alpha_{mk} = (p_{00}^m + p_{01}^m \cdot D_{nom}) - \left(p_{00}^k + p_{01}^k \cdot D_{nom}\right)$$

$$\beta_{mk} = (p_{10}^m + p_{11}^m \cdot D_{nom}) - \left(p_{10}^k + p_{11}^k \cdot D_{nom}\right)$$

$$\gamma_{mk} = (p_{20}^m + p_{21}^m \cdot D_{nom}) - \left(p_{20}^k + p_{21}^k \cdot D_{nom}\right)$$

with $D_{nom}$ denoting the nominal scanner exposure dose and mk denoting a combination of a first candidate sub-target m and a second candidate sub-target *k*.

At step 715, target combinations of a fourth sub-target (sub-target A) with combinations of a first sub-target (sub-target B) and a second sub-target (sub-target C) are determined, such that they generate $Signal_1$ and $Signal_2$ with desired characteristics. One desired characteristic may be that a difference between each combination of a combination pair *mk, mk'* is sufficient such that the sub-target combinations have different tilts through focus (where *m, k* and *k'* index the fourth sub-target, first sub-target and second sub-target respectively). Tilt may refer to the strength of the second delta coefficient $\beta_{mk}$ (linear coefficient) with respect to the third delta coefficient $\gamma_{mk}$ (quadratic coefficient). For example, if $\beta_{mk} \gg \gamma_{mk}$ then the tilt through focus is stronger than the curvature through focus. Another desired characteristic may be that each combination of a combination pair *mk, mk'* has approximately the same strength.

As such, this step 715 may comprise finding, per fourth sub-target design, unique combinations of *k* and *k'* that meet,

$$abs(\alpha_{mk} - \alpha_{mk'}) \leq \alpha_{threshold}; and\ abs(\beta_{mk} - \beta_{mk'}) \geq \beta_{threshold}$$

The check on $\alpha_{mk} - \alpha_{mk'}$ ensures both target combinations have (roughly) the same strength. The check on $\beta_{mk} - \beta_{mk'}$ ensures that the target combinations have different tilts through focus (e.g., a sufficiently large best focus offset). $\alpha_{threshold}$

is a first delta coefficient threshold value and $\beta_{threshold}$ is a second delta coefficient threshold value.

At step 720, the candidate sub-target to be used for normalization is determined. The result of the previous step 715 is a list of suitable combinations of candidate sub-targets for the fourth sub-target, first sub-target and second sub-target (e.g., suitable first and second sub-targets for each suitable fourth sub-target). This step aims to find a third sub-target or normalization sub-target (sub-target D) for each fourth sub-target A which meet the following criteria:

$$abs(\alpha_{mk}) \geq \alpha_{min} \text{ [to ensure no division by too small a number]}$$

$$abs(\beta_{mk}) \leq \beta_{max} \text{ and [to ensure normalization is sufficiently constant through Dose/Focus]}$$

$$abs(\gamma_{mk}) \leq \gamma_{max} \text{ [to ensure normalization is sufficiently constant through Dose/Focus]}$$

where m indexes the fourth sub-target (target A) and k indexes the third sub-target (target D). $\alpha_{min}$ is a normalization first delta coefficient threshold value, $\beta_{max}$ is a normalization second delta coefficient threshold value and $\gamma_{max}$ is a normalization third delta coefficient threshold value. This results in a list of candidate sub-target numbers to be used per sub-target A for normalization.

At step 725, the results of steps 715 and 720 are combined, and key performance indicators (KPIs) may be assessed to identify one or more viable combinations, e.g., one or more viable four sub-target combinations, usable as a target, which may be called a viable target. Step 715 yields a list of viable candidate sub-target combinations for the first and second sub-targets, per candidate fourth sub-target, and step 720 yield a list of viable candidate third (normalization) sub-targets per fourth sub-target. Viable in this context describes sub-targets and combinations thereof which meet the criteria outlined in steps 715 and 720.

Step 725 may be further divided into the flowchart of Figure 8. At step 800, all candidates of viable targets, i.e., viable candidate targets; i.e., all sub-target combinations (of four sub-targets A, B, C, D) which meet the criteria outlined in steps 715 and 720 are determined and constructed (e.g., modeled or exposed depending on whether this step is simulated or based on actual measurements). At step 805, an optimization signal $Signal_n^{RO}(F, D)$ may be created over a focus range and dose range of interest, where n=1 and 2 (i.e., first signal and second signal as has been described). At step 810, a monitor signal $Signal_n^{monitor}$ may be calculated over a 2D Focus/Dose grid. At step 815, an error signal derived from the difference of the optimization signal and monitor signal is minimized to find focus and dose values $Focus_{get}$, $Dose_{get}$ for each viable candidate target. This may use the equation for *error(F, D)* recited above. At step 820, per get value and corresponding set value (i.e., as set in the simulation or on the scanner), the focus sensitivity FS and dose sensitivity DS may be calculated. Focus sensitivity FS and dose sensitivity DS may be determined from the relationship of the signal data with focus and dose; this may describe determining how the signal varies with focus and/or dose. At step 825, each candidate target may be assessed, e.g., in accordance with the following KPIs: Maximum Dose/Focus set-get error over the 2D grid and Minimum DS/FS over the 2D grid.

The target(s) chosen at this step may meet following criteria:

$$Dose_{set-get} \leq Dose\ error_{max} \quad \text{(optional)}$$

$$Focus_{set-get} \leq Focus\ error_{max}$$

$$FS \geq FS_{min}$$

$$DS \geq DS_{min} \text{ (optional)}$$

wherein *Dose error$_{max}$* is a dose get-set error threshold value, *Focus error$_{max}$* is a focus get-set error threshold value, *FS$_{min}$* is a focus sensitivity threshold value and *DS$_{min}$* is a dose sensitivity threshold value.

The actual target chosen may be a preferred compromise and/or best compromise for these three criteria, the best performing target for all three criteria (if there is one) or any target meeting these criteria (possibly taking into account one or more secondary criteria, e.g., relating to design rules or preferred arrangements). Dose sensitivity and/or dose error are optionally assessed depending on the importance of dose metrology (i.e., the inference fitting described above may optionally be done only for focus, using a nominal dose value). It may be that, in selecting a compromise, these criteria may have unequal importance, e.g., focus sensitivity may be considered most important and prioritised (e.g., the target chosen may be the most focus sensitive of those which meet the relevant criteria).

Any of the simulations described above may be performed using a computational lithography module which is able to simulate the lithography process of transferring the patterning device pattern onto a resist layer of a substrate and a computational metrology module able to simulate metrology operations on said patterning device pattern.

In some embodiments, an optimization process of a system may be represented as a cost function. The optimization process may comprise finding a set of parameters (design variables, process variables, inspection operation variables, etc.) of the system that minimizes the cost function. The term "design variables" as used herein comprises a set of parameters of a lithographic projection apparatus or a lithographic process, for example, parameters a user of the lithographic projection apparatus can adjust, or image characteristics a user can adjust by adjusting those parameters. It should be appreciated that any characteristics of a lithographic projection process, including those of the source, the patterning device, the projection optics, or resist characteristics can be among the design variables in the optimization. The cost function can have any suitable form depending on the goal of the optimization. For example, the cost function can be weighted root mean square (RMS) of deviations of certain characteristics (evaluation points) of the system with respect to the intended values (e.g., ideal values) of these characteristics. The cost function may often be a non-linear function of the design variables. Then standard optimization techniques may be used to minimize the cost function.

A further embodiment is a method of designing a focus target. The method comprises the following steps: 1) obtaining a pool of candidate sub-targets; 2) obtaining measurement parameter data for each candidate sub-target in said pool of candidate sub-targets, over a focus range of interest and a dose range of interest; 3) fitting, per candidate sub-target, said measurement parameter data over focus and dose; and 4) determining one or more targets, each target comprising a combination of candidate sub-targets.

A further embodiment is a measurement target for determination of a parameter of a lithographic process, optionally the parameter is focus (optionally focus and dose) of the lithographic process. The target comprises at least a first sub-target, a second sub-target, a third sub-target, and a fourth sub-target. Each of the sub-targets has different design than the other targets. Optionally the sub-targets are largely or substantially symmetrical sub-targets (e.g., all of the sub-targets may be substantially symmetrical). The sub-targets may comprise two substantially sensitive sub-targets for the parameter, e.g. first sub-target B and second sub-target C, and two substantially insensitive sub-targets for the parameter: e.g. third sub-target D and fourth sub-target A. The parameter of the lithographic process is determined based on measurement parameter data of the first sub-target, the second sub-target, the third sub-target, and the fourth sub-target.

Further embodiments are disclosed in the subsequent numbered clauses:

1. A method of metrology, comprising:

obtaining a first measurement parameter value relating to at least a first sub-target;
obtaining a third measurement parameter value relating to at least a third sub-target; and
determining at least a focus parameter from at least said first measurement parameter value, said determination being normalized using at least said third measurement parameter value, said at least third sub-target comprising a normalization sub-target comprising substantially no or minimal focus sensitivity.

2. A method as claimed in clause 1, further obtaining a second measurement parameter value relating to at least a second sub-target; and
determining at least a focus parameter from said first measurement parameter value and said second measurement parameter value.

3. A method as claimed in clause 2, wherein said focus parameter is determined from a difference and/or comparison of said first measurement parameter value and said second measurement parameter value.

4. A method as claimed in clause 2 or 3, comprising:

obtaining a fourth measurement parameter value from a fourth sub-target;
determining a first signal from a difference and/or comparison of said fourth measurement parameter value and said first measurement parameter value, normalized by a difference and/or comparison of said fourth measurement parameter value and said third measurement parameter value;
determining a second signal from a difference and/or comparison of said fourth measurement parameter value and said second measurement parameter value, normalized by a difference and/or comparison of said fourth measurement parameter value and said third measurement parameter value; and
determining said focus parameter from said first signal and said second signal.

5. A method as claimed in clause 4, wherein said determination step comprises further determining a dose parameter from said first signal and said second signal.

6. A method as claimed in clause 5, wherein said determination step comprises determining the dose parameter and focus parameter which minimizes a mismatch error between optimization signal data and monitor signal data, wherein said optimization signal data comprises optimization first signal data and optimization second signal data for which at least said focus parameter is varied and said monitor signal data comprises said first signal and second signal.

7. A method as claimed in clause 6, wherein said optimization signal data comprises said optimization first signal data and optimization second signal data for which said focus parameter and said dose parameter is varied.

8. A method as claimed in any of clauses 4 to 7, wherein said first sub-target, second sub-target, third sub-target and fourth sub-target are all comprised within a single target, measurable in a single acquisition.

9. A method as claimed in any of clauses 4 to 8, comprising an initial target selection step of selecting each of said first sub-target, second sub-target, third sub-target and fourth sub-target from a pool of candidate sub-targets.

10. A method as claimed in clause 9, wherein said target selection step comprises:

    obtaining a pool of candidate sub-targets;
    obtaining measurement parameter data comprising respective measurement parameter values for each candidate sub-target in said pool of candidate sub-targets, over a focus range of interest and a dose range of interest;
    fitting, per candidate sub-target, said measurement parameter values over focus and dose in terms of a plurality of fit coefficients;
    determining, from said plurality of fit coefficients, a plurality of delta coefficients for different pairs of said candidate sub-targets; and
    assessing said plurality of delta coefficients against one or more criteria to determine one or more viable targets, each viable target comprising a viable combination of four candidate sub-targets to be used as said first sub-target, second sub-target, third sub-target and fourth sub-target.

11. A method as claimed in clause 10, wherein each said delta coefficient is determined from a difference of fit coefficients relating to a first candidate sub-target of each pair of candidate sub-targets and of fit coefficients relating to a second candidate sub-target of each pair of candidate sub-targets.

12. A method as claimed in clause 10 or 11, wherein said fitting step comprises a two dimensional, second order fitting, such that said plurality of fit coefficients comprise zero order focus term coefficients, first order focus term coefficients and second order focus term coefficients.

13. A method as claimed in clause 12, wherein:

    said zero order focus term coefficients comprise a constant coefficient and a dose coefficient,
    said first order focus term coefficients comprise a focus coefficient and a focus-dose product coefficient; and
    said second order focus term coefficients a focus-squared coefficient and a focus-squared-dose product coefficient.

14. A method as claimed in clause 12 or 13, wherein said delta coefficients comprise a first delta coefficient determined from said zero order focus term coefficients, a second delta coefficient determined from said first order focus term coefficients and a third delta coefficient determined from said second order focus term coefficients.

15. A method as claimed in clause 14, wherein:

    said first delta coefficient is determined from a difference of said zero order focus term coefficients of a first candidate sub-target of each pair of candidate sub-targets and said zero order focus term coefficients of a second candidate sub-target of each pair of candidate sub-targets;
    said second delta coefficient is determined from a difference of said first order focus term coefficients of a first candidate sub-target of each pair of candidate sub-targets and said first order focus term coefficients of a second candidate sub-target of each pair of candidate sub-targets;
    said first delta coefficient is determined from a difference of said second order focus term coefficients of a first candidate sub-target of each pair of candidate sub-targets and said second order focus term coefficients of a second candidate sub-target of each pair of candidate sub-targets;
    and wherein each dose related focus term coefficient is multiplied by a nominal dose value.

16. A method as claimed in clause 14 or 15, wherein said assessing step comprises determining viable combinations of said first sub-target, second sub-target and third sub-target by assessing whether a difference in respective said second delta coefficients for a first pair of said candidate sub-targets and a second pair of said candidate sub-targets is not less than a second delta coefficient threshold value, for different combinations of first and second pairs of said candidate sub-targets.

17. A method as claimed in clause 14, 15 or 16, wherein said assessing step comprises determining viable combinations of said first sub-target, second sub-target and third sub-target by assessing whether a difference in respective said first delta coefficients for a first pair of said candidate sub-targets and a second pair of said candidate sub-targets is not greater than a first delta coefficient threshold value, for different combinations of first and second pairs of said candidate sub-targets.

18. A method as claimed in clause 16 or 17, wherein said assessing step comprises determining viable combinations of said first sub-target and fourth sub-target by assessing whether said first delta coefficient for each pair of said candidate sub-targets is not less than a normalization first delta coefficient threshold value.

19. A method as claimed in clause 16, 17 or 18, wherein said assessing step comprises determining viable combinations of said first sub-target and fourth sub-target by assessing whether:

said second delta coefficient for each pair of said candidate sub-targets is not greater than a normalization second delta coefficient threshold value; and
said third delta coefficient for each pair of said candidate sub-targets is not greater than a normalization third delta coefficient threshold value.

20. A method as claimed in clause 18 or 19, comprising combining the determined viable combinations of said first sub-target and fourth sub-target and the determined viable combinations of said first sub-target, second sub-target and third sub-target to determine said one or more viable targets.

21. A method as claimed in any of clauses 10 to 20, comprising selecting at least one of said one or more viable targets.

22. A method as claimed in clause 21, wherein said selecting step comprises:

determining a focus get-set error and focus sensitivity for each of said one or more viable targets; and
selecting from said one or more viable targets, those targets for which said focus sensitivity is not less than a focus sensitivity threshold value and/or a focus get-set error is not less than a focus get-set error threshold value.

23. A method as claimed in clause 22, wherein said selecting step further comprises:

determining a dose get-set error and dose sensitivity for each of said one or more viable targets; and
selecting from said one or more viable targets, those targets for which said dose sensitivity is not less than a dose sensitivity threshold value and/or a dose get-set error is not less than a dose get-set error threshold value.

24. A method as claimed in any preceding clause, wherein said first sub-target, or a combination of said first sub-target and second sub-target comprise a focus sensitivity above a focus sensitivity threshold.

25. A method as claimed in any preceding clause, wherein at least said third sub-target comprises a focus sensitivity below a focus sensitivity threshold value.

26. A method as claimed in any preceding clause, wherein each of said sub-targets is substantially symmetrical.

27. A method as claimed in any of clauses 1 to 25, wherein said first measurement parameter value describes a focus-dependent asymmetry of said first sub-target.

28. A method as claimed in any preceding clause, wherein each said measurement parameter value comprises an intensity metric.

29. A method as claimed in clause 28, wherein said intensity metric comprises an average of respective intensities of complementary diffraction orders from each said sub-target.

30. A method as claimed in any preceding clause, comprising measuring a target to obtain each of said measurement parameter values.

31. A method as claimed in any preceding clause, wherein said third sub-target comprises a dedicated normalization sub-target, such that measurement data from said normalization sub-target is used for the sole purpose of normalization.

32. A method of designing a focus target, comprising:

obtaining a pool of candidate sub-targets;
obtaining measurement parameter data comprising respective measurement parameter values for each candidate sub-target in said pool of candidate sub-targets, over a focus range of interest and a dose range of interest;
fitting, per candidate sub-target, said measurement parameter values over focus and dose in terms of a plurality of fit coefficients;
determining, from said plurality of fit coefficients, a plurality of delta coefficients for different pairs of said candidate sub-targets; and
assessing said plurality of delta coefficients against one or more criteria to determine one or more viable targets, each viable target comprising a viable combination of candidate sub-targets.

33. A method as claimed in clause 32, wherein each said delta coefficient is determined from a difference of fit coefficients relating to a first candidate sub-target of each pair of candidate sub-targets and of fit coefficients relating to a second candidate sub-target of each pair of candidate sub-targets.

34. A method as claimed in clause 32 or 33, wherein said fitting step comprises a two dimensional, second order fitting, such that said plurality of fit coefficients comprise zero order focus term coefficients, first order focus term coefficients and second order focus term coefficients.

35. A method as claimed in clause 34, wherein:

said zero order focus term coefficients comprise a constant coefficient and a dose coefficient,
said first order focus term coefficients comprise a focus coefficient and a focus-dose product coefficient; and
said second order focus term coefficients a focus-squared coefficient and a focus-squared-dose product coefficient.

36. A method as claimed in clause 34 or 35, wherein said delta coefficients comprise a first delta coefficient determined from said zero order focus term coefficients, a second delta coefficient determined from said first order focus term coefficients and a third delta coefficient determined from said second order focus term coefficients.

37. A method as claimed in clause 36, wherein:

said first delta coefficient is determined from a difference of said zero order focus term coefficients of a first candidate sub-target of each pair of candidate sub-targets and said zero order focus term coefficients of a second candidate sub-target of each pair of candidate sub-targets;
said second delta coefficient is determined from a difference of said first order focus term coefficients of a first candidate sub-target of each pair of candidate sub-targets and said first order focus term coefficients of a second candidate sub-target of each pair of candidate sub-targets;
said first delta coefficient is determined from a difference of said second order focus term coefficients of a first candidate sub-target of each pair of candidate sub-targets and said second order focus term coefficients of a second candidate sub-target of each pair of candidate sub-targets;
and wherein each dose related focus term coefficient is multiplied by a nominal dose value.

38. A method according to any of clauses 32 to 37, wherein each viable target comprises a viable combination of a first sub-target, a second sub-target, a third sub-target and a fourth sub-target.

39. A method as claimed in clause 38, wherein said assessing step comprises determining viable combinations of said first sub-target, second sub-target and third sub-target by assessing whether a difference in respective said second delta coefficients for a first pair of said candidate sub-targets and a second pair of said candidate sub-targets is not less than a second delta coefficient threshold value, for different combinations of first and second pairs of said candidate sub-targets.

40. A method as claimed in clause 38 or 39, wherein said assessing step comprises determining viable combinations of said first sub-target, second sub-target and third sub-target by assessing whether a difference in respective said first delta coefficients for a first pair of said candidate sub-targets and a second pair of said candidate sub-targets is not greater than a first delta coefficient threshold value, for different combinations of first and second pairs of said candidate sub-targets.

41. A method as claimed in clause 39 or 40, wherein said assessing step comprises determining viable combinations of said first sub-target and fourth sub-target by assessing whether said first delta coefficient for each pair of said candidate sub-targets is not less than a normalization first delta coefficient threshold value.

42. A method as claimed in clause 39, 40 or 41, wherein said assessing step comprises determining viable combinations of said first sub-target and fourth sub-target by assessing whether:

said second delta coefficient for each pair of said candidate sub-targets is not greater than a normalization second delta coefficient threshold value; and
said third delta coefficient for each pair of said candidate sub-targets is not greater than a normalization third delta coefficient threshold value.

43. A method as claimed in clause 41 or 42, comprising combining the determined viable combinations of said first sub-target and fourth sub-target and the determined viable combinations of said first sub-target, second sub-target and third sub-target to determine said one or more viable targets.

44. A method as claimed in any of clauses 32 to 43, comprising selecting at least one of said one or more viable targets.

45. A method as claimed in clause 44, wherein said selecting step comprises:

determining a focus get-set error and focus sensitivity for each of said one or more viable targets; and
selecting from said one or more viable targets, those targets for which said focus sensitivity is not less than a focus
sensitivity threshold value and/or a focus get-set error is not less than a focus get-set error threshold value.

46. A method as claimed in clause 45, wherein said selecting step further comprises:

determining a dose get-set error and dose sensitivity for each of said one or more viable targets; and
selecting from said one or more viable targets, those targets for which said dose sensitivity is not less than a dose
sensitivity threshold value and/or a dose get-set error is not less than a dose get-set error threshold value.

47. A method as claimed in any of clauses 32 to 46, wherein each of said candidate sub-targets is substantially symmetrical.

48. A method as claimed in any of clauses 32 to 47, comprising:
exposing a focus target on a substrate in accordance with at least one of said viable targets.

49. A method as claimed in clause 48, comprising measuring said focus target to determine a focus setting at which said focus target was exposed.

50. A reticle comprising focus target features arranged to pattern a radiation beam, said focus target features corresponding to said at least one of said viable targets as determined by the method of any of clauses 32 to 47.

51. A substrate comprising at least one focus target corresponding to said at least one of said viable targets as determined by the method of any of clauses 32 to 47.

52. A computer program comprising program instructions operable to perform the method of any of clauses 1 to 47, when run on a suitable apparatus.

53. A non-transient computer program carrier comprising the computer program of clause 41.

54. A processing system comprising a processor and a storage device comprising the computer program of clause 41.

55. A lithographic apparatus comprising the processing system of clause 54.

56. A non-transitory computer program product comprising machine-readable instructions therein, the instructions, upon execution by a computer system, configured to cause the computer system to at least cause performance of the method of any of claims 1 to 47.

57. A metrology device operable to perform the method of any of claims 1 to 47.

58. A measurement target for determination of a parameter of a lithographic process, the target comprising at least a first sub-target, a second sub-target, a third sub-target, and a fourth sub-target, wherein each of the sub-targets has different design than the other targets, wherein the sub-targets comprise two substantially sensitive sub-targets for the parameter, and two substantially insensitive sub-targets for the parameter, and wherein the parameter of the lithographic process is determined based on measurement parameter data of the first sub-target, the second sub-target, the third sub-target, and the fourth sub-target.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Where the context allows, embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

**Claims**

1. A method of metrology, comprising:

   obtaining a first measurement parameter value relating to at least a first sub-target;
   obtaining a third measurement parameter value relating to at least a third sub-target; and
   determining at least a focus parameter from at least said first measurement parameter value, said determination being normalized using at least said third measurement parameter value, said at least third sub-target comprising a normalization sub-target comprising substantially no or minimal focus sensitivity.

2. A method as claimed in claim 1, further obtaining a second measurement parameter value relating to at least a second sub-target; and
   determining at least a focus parameter from said first measurement parameter value and said second measurement parameter value.

3. A method as claimed in claim 2, wherein said focus parameter is determined from a difference and/or comparison of said first measurement parameter value and said second measurement parameter value.

4. A method as claimed in claim 2 or 3, comprising:

   obtaining a fourth measurement parameter value from a fourth sub-target;
   determining a first signal from a difference and/or comparison of said fourth measurement parameter value and said first measurement parameter value, normalized by a difference and/or comparison of said fourth measurement parameter value and said third measurement parameter value;
   determining a second signal from a difference and/or comparison of said fourth measurement parameter value and said second measurement parameter value, normalized by a difference and/or comparison of said fourth measurement parameter value and said third measurement parameter value; and
   determining said focus parameter from said first signal and said second signal.

5. A method as claimed in claim 4, wherein said determination step comprises further determining a dose parameter from said first signal and said second signal.

6. A method as claimed in any of claims 4 or 5, wherein said first sub-target, second sub-target, third sub-target and fourth sub-target are all comprised within a single target, measurable in a single acquisition.

7. A method as claimed in any of claims 4 to 6, comprising an initial target selection step of selecting each of said first sub-target, second sub-target, third sub-target and fourth sub-target from a pool of candidate sub-targets.

8. A method as claimed in any of claims 2 to 7, wherein said first sub-target, or a combination of said first sub-target and second sub-target comprise a focus sensitivity above a focus sensitivity threshold.

9. A method as claimed in any preceding claim, wherein at least said third sub-target comprises a focus sensitivity below a focus sensitivity threshold value.

10. A method as claimed in any preceding claim, wherein each of said sub-targets is substantially symmetrical.

11. A method as claimed in any of claims 1 to 9, wherein said first measurement parameter value describes a focus-dependent asymmetry of said first sub-target.

12. A method as claimed in any preceding claim, wherein said third sub-target comprises a dedicated normalization sub-target, such that measurement data from said normalization sub-target is used for the sole purpose of normalization.

13. A non-transitory computer program product comprising machine-readable instructions therein, the instructions, upon execution by a computer system, configured to cause the computer system to at least cause performance of the method of any of claims 1-12.

14. A metrology device operable to perform the method of any of claims 1 to 12.

15. A measurement target for determination of a parameter of a lithographic process, the target comprising at least a first sub-target, a second sub-target, a third sub-target, and a fourth sub-target,

> wherein each of the sub-targets has different design than the other targets,
> wherein the sub-targets comprise two substantially sensitive sub-targets for the parameter, and two substantially insensitive sub-targets for the parameter, and
> wherein the parameter of the lithographic process is determined based on measurement parameter data of the first sub-target, the second sub-target, the third sub-target, and the fourth sub-target.

# Fig. 1

Fig. 2

Fig. 3

(a)

(b)

Fig. 4

Fig. 5

(a)

(b)

(c)

Fig. 6

Fig. 7

Fig. 8

# EUROPEAN SEARCH REPORT

Europäisches
Patentamt

European
Patent Office

Office européen
des brevets

**Application Number**

EP 23 20 8139

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X,D | US 2016/363871 A1 (VAN OOSTEN ANTON BERNHARD [BE] ET AL) 15 December 2016 (2016-12-15) | 14 | INV. G03F7/20 |
| A | * paragraphs [0078] – [0085], [0103] – [0105], [0118]; figures 5,7 * | 1-13,15 | |
| X | EP 4 155 821 A1 (ASML NETHERLANDS BV [NL]) 29 March 2023 (2023-03-29) | 14,15 | |
| A | * paragraphs [0044] – [0055]; figures 6-7 * | 1-13 | |
| X | US 2017/153554 A1 (HINNEN PAUL CHRISTIAAN [NL] ET AL) 1 June 2017 (2017-06-01) | 14,15 | |
| A | * paragraphs [0089], [0090], [0100], [0127], [0128], [0135] – [0139]; figures 4,5,10 * | 1-13 | |
| X | EP 4 160 314 A1 (ASML NETHERLANDS BV [NL]) 5 April 2023 (2023-04-05) | 14,15 | |
| A | * paragraph [0010]; claims 1,2; figures 6-9 * | 1-13 | TECHNICAL FIELDS SEARCHED (IPC) G03F |

The present search report has been drawn up for all claims

| Place of search | Date of completion of the search | Examiner |
|---|---|---|
| Munich | 26 April 2024 | Roesch, Guillaume |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 23 20 8139

This annex lists the patent family members relating to the patent documents cited in the above-mentioned European search report.
The members are as contained in the European Patent Office EDP file on
The European Patent Office is in no way liable for these particulars which are merely given for the purpose of information.

26-04-2024

| Patent document cited in search report | | | Publication date | Patent family member(s) | | | Publication date |
|---|---|---|---|---|---|---|---|
| US 2016363871 | A1 | | 15-12-2016 | CN | 107710073 | A | 16-02-2018 |
| | | | | IL | 256114 | A | 28-02-2018 |
| | | | | IL | 302339 | A | 01-06-2023 |
| | | | | JP | 6618551 | B2 | 11-12-2019 |
| | | | | JP | 2018517177 | A | 28-06-2018 |
| | | | | KR | 20180016589 | A | 14-02-2018 |
| | | | | NL | 2016864 | A | 12-12-2016 |
| | | | | TW | 201708972 | A | 01-03-2017 |
| | | | | US | 2016363871 | A1 | 15-12-2016 |
| | | | | US | 2018046091 | A1 | 15-02-2018 |
| | | | | WO | 2016198283 | A1 | 15-12-2016 |
| EP 4155821 | A1 | | 29-03-2023 | EP | 4155821 | A1 | 29-03-2023 |
| | | | | IL | 310642 | A | 01-04-2024 |
| | | | | TW | 202318113 | A | 01-05-2023 |
| | | | | WO | 2023046410 | A1 | 30-03-2023 |
| US 2017153554 | A1 | | 01-06-2017 | CN | 104395830 | A | 04-03-2015 |
| | | | | KR | 20150032876 | A | 30-03-2015 |
| | | | | KR | 20170010110 | A | 25-01-2017 |
| | | | | TW | 201403253 | A | 16-01-2014 |
| | | | | TW | 201732413 | A | 16-09-2017 |
| | | | | US | 2015338749 | A1 | 26-11-2015 |
| | | | | US | 2017153554 | A1 | 01-06-2017 |
| | | | | WO | 2013189724 | A2 | 27-12-2013 |
| EP 4160314 | A1 | | 05-04-2023 | EP | 4160314 | A1 | 05-04-2023 |
| | | | | TW | 202328823 | A | 16-07-2023 |
| | | | | TW | 202403470 | A | 16-01-2024 |
| | | | | WO | 2023057237 | A1 | 13-04-2023 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20100328655 A
- US 2011102753 A1
- US 20120044470 A
- US 20110249244 A
- US 20110026032 A
- EP 1628164 A
- US 2016363871 A1